# EUROPÄISCHE PATENTSCHRIFT

(11) **EP 0 792 381 B1**
(45) Veröffentlichungstag und Bekanntmachung des Hinweises auf die Patenterteilung: **28.04.1999**
(21) Anmeldenummer: 95937061.0
(22) Anmeldetag: 10.11.1995
(51) Int. Cl.: C23C 14/56

(54) **VERFAHREN ZUR BESCHICHTUNG VON SUBSTRATEN UND VORRICHTUNG ZUR DURCHFÜHRUNG DES VERFAHRENS**
PROCESS FOR COATING SUBSTRATES AND A DEVICE FOR CARRYING OUT SAID PROCESS
PROCEDE DE REVETEMENT DE SUBSTRATS ET DISPOSITIF PERMETTANT DE METTRE EN OEUVRE LEDIT PROCEDE

(30) Priorität: 18.11.1994 DE 4441117
(43) Veröffentlichungstag der Anmeldung: 03.09.1997
(73) Patentinhaber: Gesellschaft für Plasma Applikationen mbH, 51379 Leverkusen (DE)
(72) Erfinder: LOHMANN, Hans-Jürgen, D-51379 Leverkusen (DE)
(74) Vertreter: Godemeyer, Thomas, Dr.
(86) Internationale Anmeldenummer: EP9504424
(87) Internationale Veröffentlichungsnummer: WO9616197

(56) Entgegenhaltungen:
- EP-A- 0 275 021
- DD-A- 201 461
- DD-A- 294 511
- US-A- 3 568 632
- US-A- 4 500 407
- RESEACH DISCLOSURE, Nr. 260, Dezember 1985 GB, Seite 618 DISCLOSED ANONYMOUSLY '26025 ,CLEAN VACUUM SYSTEN TECHNIQUE TO OBTAIN CLEAN WAFERS'
- PATENT ABSTRACTS OF JAPAN Bd. 013, Nr. 151 (C-584) 12 April 1989 & JP,A,63 307 272 (HITACHI LTD) 14 Dezember 1988
- PATENT ABSTRACTS OF JAPAN Bd. 008, Nr. 273 (C-256) 13 Dezember 1984 & JP,A,59 143 069 (FUJITSU KK) 16 August 1984
- M Wutz et. al. "Theorie und Praxis der Vakuumtechnik", 3. Auflage, 1986, Verlag F. Vieweg & Sohn, Braunschweig/Wiesbaden, DE S. 610
- Leybold AG, 181.06.01 Katalog HV 300, Teil B 4, Auflage 05/91, S. 3, 5 - 7, 11, 14, 15
- Proceedings of The Eighth International Vacuum Congress, September 22-26, 1980, Cannes, France, Band II "Vacuum Technology and Vacuum Metallurgy", M Grundner et al. "Flushing Process as compared to High Vacuum Pumping" pp.74-77

## Beschreibung

Gegenstand der Erfindung ist ein Verfahren und eine Vorrichtung zur Beschichtung von Substraten umfassend das Einbringen des zu beschichtenden Substrates in eine Vakuumkammer mit einer oder mehreren Verdampfungsquellen, Evakuieren der Vakuumkammer und Aufheizen der Substrate und Beschichten des Substrates mittels Bogenentladung, wobei Vakuumkammer ausschließlich unter Verwendung von einer oder meheren Vorvakuumpumpen erakuiert wird.

Werkzeuge aus Metall oder anderen Werkstoffen sind durch Abrieb und Temperaturschwankungen einem erheblichen Verschleiß an der Oberfläche ausgesetzt. Es ist daher bekannt, die Oberfläche von Werkzeugen mit harten und verschleißmindernden Schichten zu versehen. So werden beispielsweise Verbindungen wie Titannitrid, Titancarbonitrid, Titancarbid und Mehrlagenschichten oder Mischschichten wie Titanaluminiumnitrid auf die Werkzeuge aufgebracht. Es sind im wesentlichen zwei Verfahren bekannt, mit denen diese Beschichtungen erzeugt werden. Zum einen das sogenannte CVD-Verfahren (chemical vapour deposition), bei dem die Werkzeuge bei Temperaturen von 800 bis 1100°C beschichtet werden. Dieses Verfahren hat jedoch den Nachteil, daß aufgrund der sehr hohen Temperaturen Form- und Gefügeveränderungen am Werkzeug auftreten, so daß eine Nachbehandlung der Werkzeuge notwendig ist.

Ein weiteres Beschichtungsverfahren ist das sogenannte PVD-Verfahren (physical vapour deposition), das bei Temperaturen unter 500°C erfolgt und damit die oben genannten Nachteile des CVD-Verfahrens vermeidet. Unter PVD-Verfahren wird ein Verfahren verstanden, bei dem das Beschichtungsmaterial verdampft oder zerstäubt und anschließend ionisiert wird und auf ein mit einer negativen Substratvorspannung (Bias) versehenes Substrat aufgebracht wird. Bei der Durchführung dieses Beschichtungsverfahrens tritt keine Form- oder Gefügeänderung des Werkzeugs auf, so daß keine nachträgliche Bearbeitung erfolgen muß. Die einzelnen PVD-Verfahren unterscheiden sich nur in der Art ihrer Verdampfungsquelle. Bekannt sind das Aufdampfen unter Vakuum, Kathodenzerstäubung, ionisiertes reaktives Aufdampfen und Verdampfen mittels Bogenentladung oder Elektronenstrahlkanone.

Beim Aufdampfen unter Hochvakuum wird das zu verdampfende Material, beispielsweise ein Metall, in einem Tiegel erhitzt und auf das Substrat niedergeschlagen.

Ein weiteres PVD-Verfahren ist die Kathodenzerstäubung oder Hochleistungskathodenzerstäubung. Dabei wird als Verdampfungsquelle eine feste Platte benutzt, die mit einer negativen Vorspannung (Bias) versehen wird. Das in der Vakuumkammer erzeugte Plasma enthält positive Ionen, die die als Quelle benutzte feste Platte abtragen. Das abgetragene Material schlägt sich dann auf dem Substrat nieder. Bei der Hochleistungskathodenzerstäubung wird zusätzlich hinter der Kathode ein Magnetron angeordnet, das die Zerstäubungsrate durch Ablenkung der Elektronen erhöht, so daß mehr positive Ionen das Plasma abtragen können.

Aus der Wirtschaftspatentschrift DD-A-201 461 ist ein PVD-Verfahren mit Zerstäubungseinrichtung für Arbeitsdrücke zwischen 10 mPa und 1 Pa bekannt. Die Vorrichtung weist neben Drehschieber- und Wälzkolbenpumpen Kryoflächen auf.

Das Dokument Grundner, Kieser "Flushing process as compared to high vacuum pumping in sputtering plants: investigation of a new concept" in Proceedings of the eighth International Vacuum Congress, September 22-26, 1980, Cannes, Frankreich, Seiten 74 - 77 beschreibt ein neues Konzept zur Durchführung von Diodensputterverfahren, bei dem statt des Einsatzes von Hochvakuumpumpen ein Spülprozeß durchgeführt wird und hierdurch die Verunreinigungen im Sputtergas im wesentlichen unverändert bleiben.

Auch reaktive PVD-Verfahren sind bekannt, bei denen die Substanz, mit der beschichtet wird, erst in der Vakuumkammer hergestellt wird. Ein solches Verfahren ist das ionisierte, reaktive Aufdampfen (ion plating), wobei z.B. mittels eines Elektronenstrahls Verdampfungsmaterial aus einem Tiegel, der als Anode geschaltet ist, ionisiert wird. Die ionisierten Atome werden durch die negative Spannung am Substrat auf dieses hin beschleunigt. Durch Ionisation entstehen ferner positive Reaktionsgasionen, die ebenfalls auf das negative Substrat beschleunigt werden. An der Substratoberfläche entladen sich die Verdampfungsmaterial- und Reaktionsgasionen und vereinigen sich zu einer Hartstoffschicht.

Ein weiteres bekanntes PVD-Verfahren ist das Verdampfen mittels Bogenentladung (arc discharge). Bei diesem Verfahren wird mit einem oder mehreren Lichtbogenverdampfern gearbeitet, die in jeder Raumlage der Vakuumkammer angeordnet werden können. Diese Verdampfer enthalten das zu verdampfende Material. Das Verdampfungsmaterial wird als Kathode am negativen Pol einer Spannungsquelle geschaltet. Durch Kontakt der Kathodenoberfläche mit einem geerdeten Trigger wird ein elektrischer Lichtbogen erzeugt, der zwischen Kathode und Anode brennt. Dieser Lichtbogen greift die Kathode an ihrer Oberfläche an. Durch diese lokale Erhitzung wird das Kathodenmaterial verdampft und als ionisiertes Metallplasma durch eine negative Substratvorspannung (Bias) auf das Substrat hin beschleunigt. Hochionisierte und hochenergetische Metallteilchen aus dem Plasma kondensieren nach der Reaktion mit dem in die Kammer eingelassenen Reaktionsgas auf der Substratoberfläche und bilden so beispielsweise bei Verwendung von Titan als Verdampfungsmaterial eine Titannitridschicht.

Alle PVD-Verfahren werden unter Hochvakuum durchgeführt. Eine Beschichtung im Vakuum ist notwendig, damit eine Oxidation der erzeugten Schichten und der Oberflächen der Werkzeuge vermieden wird. Die Beschichtung der Substrate erfolgt durch Verdampfung oder Zerstäubung des Beschichtungsmaterials in der Vakuumkammer. Das so erzeugte dampfförmige Beschichtungsmaterial wird dann auf das Substrat geführt, teilweise unter Anwendung elektrischer Felder, und schlägt sich auf dem Substrat nieder.

Ein entscheidendes Kriterium für die Reinheit der erzeugten Schichten ist der Partialdruck der Restgase in der Vakuumkammer, der möglichst niedrig sein muß, um eine hochreine Schicht erzeugen zu können.

Nach den bisherigen PVD-Verfahren des Standes der Technik wird das Vakuum in der Vakuumkammer über eine Vakuumpumpenanlage aus Vorvakuumpumpen und Hochvakuumpumpe erzeugt. Dadurch werden der Sauerstoff, unerwünschte Gase und Restfeuchtigkeit aus der Kammer entfernt und ein Hochvakuum erzeugt, das für das Beschichtungsverfahren selbst zu hoch ist. Bei einem solchen Vakuum erfolgt nämlich im Falle des Beschichtens keine Reaktion der verdampften Metalle, beispielsweise mit einem reaktiven Gas wie Stickstoff, da die Gaskonzentration bei so niedrigem Druck für eine Reaktion zu gering ist.

Vor Durchführung der Beschichtung wird daher üblicherweise die Hochvakuumpumpe gedrosselt und Reaktionsgas zugeführt, so daß sich der Druck erhöht. Bei diesem erhöhten Druck wird dann die eigentliche Beschichtung durchgeführt.

Das nach dem Stand der Technik bei PVD-Verfahren übliche Evakuieren der Vakuumkammern mit einer Kombination aus Vorvakuum- und ein Vorvakuum benötigenden Hochvakuumpumpen hat jedoch durch die Verwendung der Hochvakuumpumpen erhebliche Nachteile. Hochvakuumpumpen sind unter anderem anfällig für Störungen, wartungsintensiv, und erfordern, je nach Art der Pumpe, lange Anlaufzeiten, während der keine Beschichtung erfolgen kann.

Im allgemeinen werden zur Erzeugung von Hochvakuum (10⁻³ - 10⁻⁷ mbar) Öldiffusionspumpen, Turbomolekularpumpen oder Cryopumpen eingesetzt.

Öldiffusionspumpen müssen auf Betriebstemperaturen von größer als 300 °C vorgeheizt und ständig mit Kühlwasser versorgt werden. Darüber hinaus muß während der gesamten Betriebszeit der Öldiffusionspumpe, also auch während der Vorwärm- und Abkühlzeit, eine Vorvakuumpumpe mit betrieben werden. Öldiffusionspumpen haben dadurch einen hohen Energieverbrauch. Sie sind weiter während des Vorwärmens und Abkühlens nicht einsetzbar und werden mit Öl betrieben, das gegebenfalls entsorgt werden muß. Während des Betriebes der Öldiffusionspumpen ist eine Ölrückströmung gegen die Saugrichtung unvermeidbar. Dadurch werden Silikon- und Kohlenstoffverbindungen aus dem Öl unerwünschterweise in die erzeugte Hartstoffschicht eingebaut. Eine Reduzierung der Öldruckströmung ist nur durch aufwendige Kühlfallen möglich.

Auch Turbomolekularpumpen weisen erhebliche Nachteile auf. Sie werden mit sehr hohen Drehzahlen betrieben und benötigen hierfür einen Frequenzumwandler. Die Pumpen sind empfindlich gegen Verunreinigungen, die prozeßbedingt entstehen und angesaugt werden können. Aus diesen Gründen müssen Vorkehrungen zum Schutz der Pumpe getroffen werden.

Weiterhin werden auch Cryopumpen verwendet. Das Funktionsprinzip dieser Pumpen besteht darin, daß gasförmige Substanzen durch Kondensation und Absorption an Kaltflächen im Inneren der Pumpe gebunden werden. Die Kaltflächen werden hierzu mit komprimiertem Helium auf Temperaturen von etwa 10 K gekühlt. Nach einer bestimmten Betriebszeit müssen diese Pumpen regeneriert werden. Dieser Prozeß besteht aus Ausheizen, Evakuieren und Abkühlen und nimmt einige Stunden in Anspruch, während der die Pumpe und damit die gesamte Anlage nicht betrieben werden können. Beim Betrieb der Cryopumpen entstehen durch den Einsatz eines Heliumkompressors und dessen Kühlung erhebliche Energiekosten.

Somit ist zusammenfassend festzustellen, daß die bisher verwendete Kombination aus Vor- und Hochvakuumpumpen erhebliche Nachteile hat. Hochvakuumpumpen sind kosten- und wartungsintensiv, sie sind technisch anspruchsvoll und daher besonders anfällig. Hochvakuumpumpen benötigen aufgrund ihrer physikalischen Gegebenheiten sehr große Anschlußdurchmesser und daher teure und wartungsintensive Ventile, die mit steigender Größe erhebliche Probleme bezüglich ihrer Dichtigkeit verursachen. Weiterhin können Hochvakuumpumpen nur in Kombination mit Vorvakuumpumpen eingesetzt werden, da sie nicht gegen Atmosphärendruck arbeiten können.

Aus Sicherheitsgründen müssen kombinierte Pumpstände aus Hochvakuumpumpen und Vorvakuumpumpen so gesteuert werden, daß Fehlbedienungen, die die Pumpen beschädigen oder zerstören können, vermieden werden. Diese Steuerungen sind prozeßspezifische Sonderanfertigungen und daher ein weiterer nachteiliger Kosten- und Risikofaktor.

Trotz dieser Nachteile wird für PVD-Verfahren zur Evakuierung der Vakuumkammer eine Kombination aus Vor- und Hochvakuumpumpe verwendet, obwohl die tatsächliche Leistung der Hochvakuumpumpe nur sehr kurz benötigt und nur beim anfänglichen Evakuieren des Vakuumbehälters voll eingesetzt wird.

Der eigentliche Beschichtungsprozeß läuft bei einem Druck ab, der allein durch den Einsatz von Vorvakuumpumpen erreicht werden kann. Auf diese Art und Weise wird eine stabile, gut haftende und gleichmäßige Beschichtung auf den zu beschichtenden Substraten erhalten. Somit dient der Einsatz der Hochvakuumpumpe lediglich der Vorbereitung des anschließenden Beschichtungsprozesses, um einen möglichst geringen Partialdruck an unerwünschten Gasen, wie z. B. Sauerstoff oder auch Wasserdampf, zu erhalten.

Die technische Aufgabe der Erfindung ist es daher, ein Verfahren zur Beschichtung von Substraten und eine Vorrichtung zur Durchführung dieses Verfahrens zur Verfügung zu stellen, das die oben genannten erheblichen Nachteile der Verwendung von Hochvakuumpumpen vermeidet und so eine wirtschaftlich erheblich vorteilhaftere, technisch einfachere Beschichtung ermöglicht.

Diese Aufgabe wird gelöst durch ein Verfahren zur Beschichtung von Substraten gemäß Anspruch 1, bei dem die Vakuumkammer ausschließlich unter Verwendung einer oder mehrerer Vorvakuumpumpen evakuiert wird. Es wurde nämlich überraschenderweise festgestellt, daß es durchaus möglich ist, ausschließlich mit Vorvakuumpumpen, die nach dem Stand der Technik in Kombination mit Hochvakuumpumpen verwendet werden, die Bogenentlandung durchzuführen und so den Einsatz von Hochvakuumpumpen überflüssig zu machen. Bevorzugte Ausführungsformen des Verfahrens nach Anspruch 1 sind in den Ansprüchen 2 bis 10 beansprucht. Unter Vorvakuumpumpen im Sinne der Erfindung werden solche Vakuumpumpen verstanden, die in einem Druckbereich von bis zu 10 mPa (10⁻⁴ mbar), bevorzugt 10 Pa bis 0,1 Pa (10⁻¹ bis 10⁻³ mbar), ihr Arbeitsgebiet haben und die auch gegen Atmosphärendruck arbeiten können. Diese werden auch als Grob- oder Feinvakuumpumpen bezeichnet. Alle Hochvakuumpumpen benötigen ein Vorvakuum, um einen Druck von 0,1 Pa bis 10 µPa (10⁻³ bis 10⁻⁷ mbar) und kleiner erzeugen zu können.

Es ist bevorzugt, daß das Ionisieren und Aufbringen des Verdampfungsmaterials auf das Substrat durch Kathodenzerstäubung oder ionisiertes reaktives Aufdampfen oder Verdampfen mittels Bogenentladung oder Elektronenstrahl oder Laser, Abkühlen und Belüften der Vakuumkammer erfolgt.

In einer besonderen Ausführungsform werden als Vorvakuumpumpen Hubkolbenvakuumpumpen, Membranvakuumpumpen, Flüssigkeitsringvakuumpumpen, Drehschiebervakuumpumpen, Vielzellenvakuumpumpen, Kreiskolbenvakuumpumpen, Sperrschiebervakuumpumpen, Wälzkolbenvakuumpumpen und Adsorptionsvakuumpumpen oder Kombinationen derselben verwendet.

Diese Pumpen können in Reihe geschaltet werden. Besonders bevorzugt ist eine Kombination aus Drehschieber- und Wälzkolbenvakuumpumpe, wobei die Wälzkolbenpumpe in Strömungsrichtung vor der Drehschieberpumpe geschaltet ist.

In einer weiteren besonderen Ausführungsform wird während des Evakuierens der Vakuumkammer diese einmal oder mehrmals mit Inertgas geflutet und danach wieder evakuiert. Als Inertgas wird in bevorzugter Weise ein Edelgas, wie He, Ne, Ar, Xe, Rn oder ein Gas, das nicht mit dem Substrat reagiert, verwendet. Weiterhin kann im Falle der reaktiven Beschichtung nach dem Evakuieren der Vakuumkammer und während des Beschichtens ein Reaktivgas in die Vakuumkammer gegeben werden.

Der Druck beträgt vorzugsweise nach dem Evakuieren bis zu 10 mPa (10⁻⁴ mbar), bevorzugt 10 Pa bis 0,1 Pa (10⁻¹ bis 10⁻³ mbar). Die Beschichtung wird dann bei Substrattemperaturen von 100°C bis 500°C durchgeführt. Um eine bessere Schichtdickenverteilung zu erhalten, kann das Substrat während des Beschichtens in Rotation versetzt werden. Diese Rotation kann eine einfache, mehrfache oder planetarische Rotation sein.

Mit dem erfindungsgemäßen Verfahren ist es erstmals möglich, Beschichtungen in gleicher Qualität, Haftfestigkeit und Härte zu erzeugen, wie nach dem Stand der Technik, jedoch ohne Verwendung von teuren, technisch anfälligen und kostenintensiven Hochvakuumpumpen. Bei dem erfindungsgemäßen Verfahren entfallen Vorwärm-, Abkühl- oder Regenerierzeiten genauso wie die Investitions- und Instandhaltungskosten für Hochvakuumpumpen und deren Steuerungen. Die Vakuumpumpen können ohne zusätzliche Ablaufsteuerung bei Bedarf ein- und ausgeschaltet werden, benötigen keine Anlaufzeiten und sind sofort betriebsbereit.

Vorvakuumpumpen sind robust und zuverlässig und nicht wartungsintensiv. Weiterhin kann in einer bevorzugten Ausführungsform in dem Pumpsystem eine Rootspumpe (Wälzkolbenpumpe) vorgeschaltet werden oder als Pumpsysteme Trockenläufer verwendet werden, um die Ölrückströmung der Pumpen zu vermeiden.

Ein weiterer Gegenstand der Erfindung ist eine Vorrichtung nach Anspruch 1, zur Durchführung des Verfahrens nach den Ansprüchen 1 bis 10 umfassend eine Vakuumkammer, eine oder mehrere Vakuumpumpen, die mit der Vakuumkammer verbunden sind, Absperr- und Gaseinlaßventile, eine in der Vakuumkammer angeordnete Substratheizvorrichtung, wobei die Vakuumkammer einen oder mehrere Ausgänge aufweist, über die sie evakuierbar und flutbar ist, eine elektrisch isolierte Drehdurchführung, um die zu beschichtenden Substrate in Rotation zu versetzen, Mittel zum Befestigen des Substrates und der Verdampfungsquelle, die in der Vakuumkammer angeordnet sind und eine elektrische Versorgung für die Verdampferquelle und für das Substrat, wobei als Vakuumpumpe ausschließlich eine oder mehrere Vorvakuumpumpen verwendet werden.

Bevorzugte Ausführungsformen der Vorrichtung nach Anspruch 11 sind in den Ansprüchen 12 bis 18 beansprucht.

In einer bevorzugten Ausführungsform werden als Vorvakuumpumpen eine oder mehrere aus der Gruppe Hubkolbenvakuumpumpen, Membranvakuumpumpen, Flüssigkeitsringvakuumpumpen, Drehschiebervakuumpumpen, Vielzellenvakuumpumpen, Kreiskolbenvakuumpumpen, Sperrschiebervakuumpumpen, Wälzkolbenvakuumpumpen und Adsorptionsvakuumpumpen verwendet.

In bevorzugter Weise können mehrere Vorvakuumpumpen in Reihe geschaltet werden. Weiterhin kann die Vorrichtung eine Drehschiebervakuumpumpe und Wälzkolbenvakuumpumpe enthalten, wobei die Wälzkolbenpumpe in Strömungsrichtung vor der Drehschieberpumpe geschaltet und angeordnet ist.

Die Verdampfungsquelle ist in einer bevorzugten Ausführungsform der Erfindung zur Vakuumkammer elektrisch isoliert angeordnet. Weiterhin kann die Verdampfungsquelle von einem Isolierring umschlossen sein und/oder hinter der Verdampfungsquelle ein Permanentmagnet oder eine elektrischen Spule angeordnet, mit der ein Magnetfeld erzeugt wird.

In einer weiteren bevorzugten Ausgestaltung der Erfindung ist die Substratheizvorrichtung eine Strahlungsheizung und im Innenraum der Vakuumkammer angeordnet. Die elektrische Versorgung für die Beschichtungsquelle ist bevorzugt stromgeregelt und für die Substrate spannungsgeregelt.

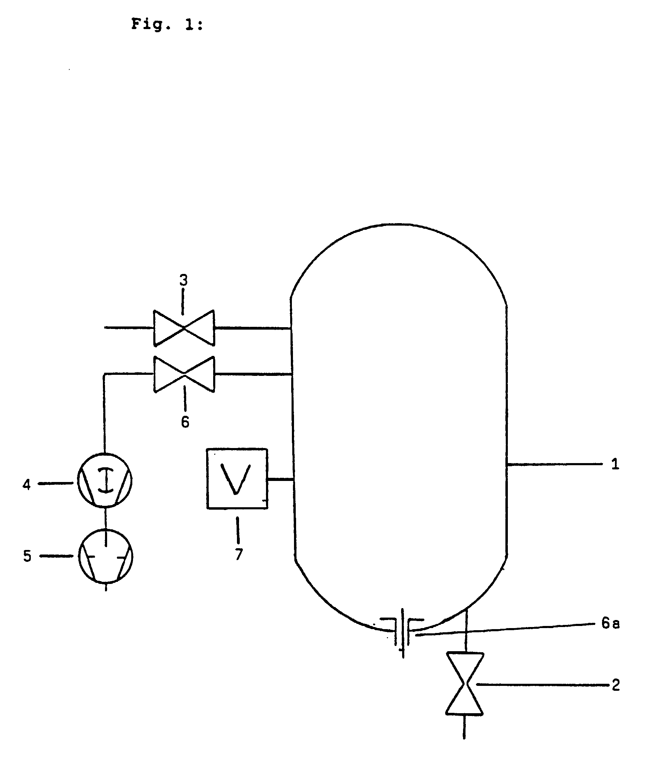

Nachfolgend werden die Figuren 1 bis 3 beschrieben, die die Erfindung näher erläutern.

Figur 1 zeigt die Anordnung der verschiedenen Bestandteile der erfindungsgemäßen Vorrichtung. Ziffer 1 bezeichnet den Vakuumbehälter, mit den Ziffern 2 sind die Prozeßgasventile bezeichnet, durch die die Prozeßgase in die Vakuumkammer geführt werden können. Die Ziffer 3 bezeichnet das Flutgasventil, das zum Belüften der Kammer verwendet wird. Ziffer 4 ist eine Vorvakuumpumpe, beispielsweise eine Wälzkolbenvakuumpumpe. Ziffer 5 ist eine weitere Vorvakuumpumpe, beispielsweise eine Drehschiebervakuumpumpe. Das Ventil 6 dient zur Steuerung der Verbindung zwischen Vakuumkammer und Vakuumpumpen. Ziffer 6a bezeichnet einen elektrisch isolierten Drehantrieb für den Substrathalter, so daß der Substrathalter während des Beschichtens gedreht werden kann. Ziffer 7 ist ein Druckaufnehmer für den Kammerdruck.

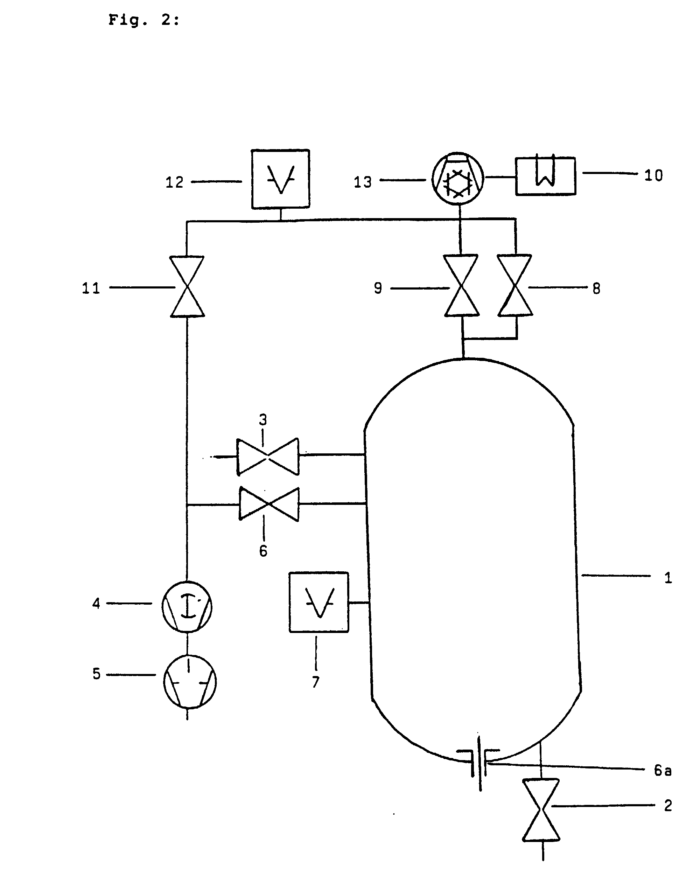

Figur 2 zeigt eine Anordnung gemäß des Standes der Technik mit einem Cryo-Pumpenstand . Die Ziffern 1 bis 7 haben dieselbe Bedeutung wie in Figur 1. Mit der Ziffer 8 ist ein Bypassventil bezeichnet, mit der Ziffer 9 das Hochvakuumventil, das eine Verbindung zwischen der Vakuumkammer 1 und der Hochvakuumpumpe 10 schafft. Das Ventil 11 ist ein Ventil für die Regenerierung der in der Figur gezeigten Cryopumpe 10. Die Ziffern 12 und 13 bezeichnen Bestandteile zum Betrieb der Hochvakuumpumpe, nämlich einen Druckaufnehmer 12 zur Vakuummessung der Cryopumpe und einen Heliumkompressor 13, der zum Betrieb von Cryopumpen erforderlich ist.

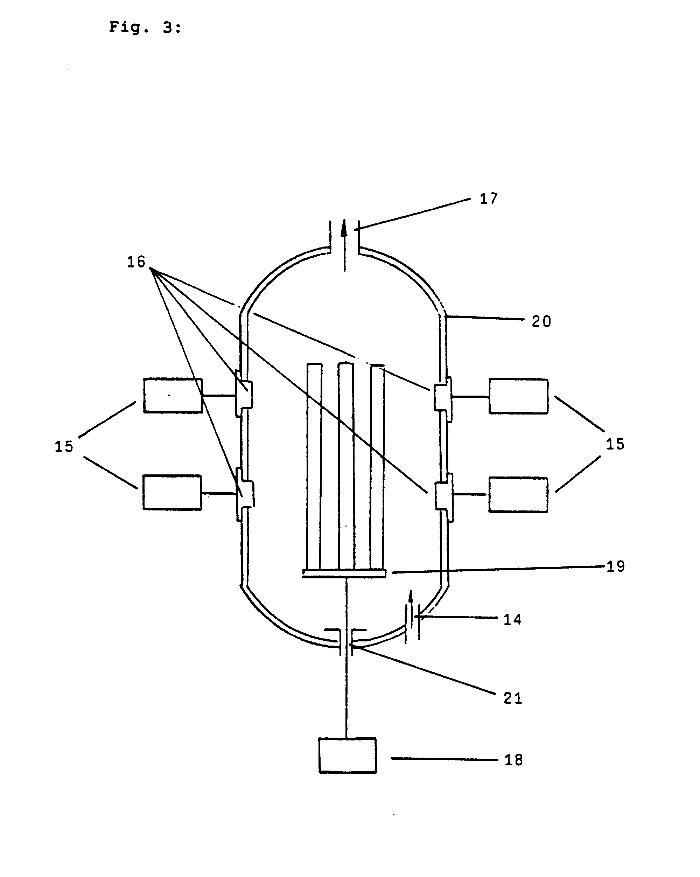

Figur 3 zeigt eine genaue Darstellung der Vakuumkammer für das Verdampfen mittels Bogenentladung. Ziffer 14 bezeichnet den Einlaß für das Reaktivgas und Prozeßgas, Ziffer 15 die Verdampferstromerzeugung. Ziffer 16 zeigt die Verdampfungsquelle, Ziffer 17 zeigt den Ausgang zum Vakuumpumpstand, Ziffer 18 bezeichnet die Substratspannungsversorgung (Bias). Ziffer 19 zeigt den Substrathalter mit den darauf fixierten Substraten und Ziffer 20 ist schließlich die Vakuumkammerwand. Ziffer 21 bezeichnet einen elektrisch von der Vakuumkammer isolierten Drehantrieb für den Substrathalter.

Grundsätzlich kann die erfindungsgemäße Vorrichtung für alle verschiedenen PVD-Verfahren eingesetzt werden, im einzelnen für das Verfahren Verdampfen mittels Bogenentladung, ionisiertes reaktives Aufdampfen und Kathodenzerstäubung. Bei allen diesen Verfahren enthält die erfindungsgemäße Vorrichtung keine Hochvakuumpumpen und führt trotzdem zu hervorragend beschichteten Werkzeugen.

## Patentansprüche

1. Verfahren zur Beschichtung von Substraten umfassend das Einbringen des zu beschichtenden Substrates in eine Vakuumkammer mit einer oder mehreren Verdampfungsquellen, Evakuieren der Vakuumkammer und Aufheizen der Substrate und Beschichten des Substrates mittels Verdampfen mittels Bogenentladung, **dadurch gekennzeichnet**, daß die Vakuumkammer ausschließlich unter Verwendung von einer oder mehreren Vorvakuumpumpen evakuiert wird.

2. Verfahren nach Anspruch 1, dadurch gekennzeichnet, daß als Vorvakuumpumpen Hubkolbenvakuumpumpen, Membranvakuumpumpen, Flüssigkeitsringvakuumpumpen, Drehschiebervakuumpumpen, Vielzellenvakuumpumpen, Kreiskolbenvakuumpumpen, Sperrschiebervakuumpumpen, Wälzkolbenvakuumpumpen und Adsorptionsvakuumpumpen oder Kombinationen derselben verwendet werden.

3. Verfahren nach den Ansprüchen 1 oder 2, dadurch gekennzeichnet, daß mehrere Vorvakuumpumpen in Reihe geschaltet werden.

4. Verfahren nach den Ansprüchen 1 bis 3, dadurch gekennzeichnet, daß eine Kombination aus Drehschieber- und Wälzkolbenvakuumpumpe verwendet wird, wobei die Wälzkolbenvakuumpumpe in Strömungsrichtung vor der Drehschiebervakuumpumpe geschaltet ist.

5. Verfahren nach den Ansprüchen 1 bis 4, dadurch gekennzeichnet, daß während des Evakuierens der Vakuumkammer diese einmal oder mehrmals mit Inertgas geflutet und wieder evakuiert wird.

6. Verfahren nach den Ansprüchen 1 bis 5, dadurch gekennzeichnet, daß als Inertgas ein Edelgas oder ein Gas, das nicht mit dem Substrat reagiert, verwendet wird.

7. Verfahren nach den Ansprüchen 1 bis 6, dadurch gekennzeichnet, daß der Druck nach dem Evakuieren bis zu 10⁻⁴ mbar beträgt.

8. Verfahren nach den Ansprüchen 1 bis 7, dadurch gekennzeichnet, daß die Beschichtung bei Substrattemperaturen von 100°C bis 500°C erfolgt.

9. Verfahren nach den Ansprüchen 1 bis 8, dadurch gekennzeichnet, daß nach dem Evakuieren der Vakuumkammer und während des Beschichtens ein Reaktivgas in die Vakuumkammer gegeben wird.

10. Verfahren nach den Ansprüchen 1 bis 9, dadurch gekennzeichnet, daß während des Beschichtens das Substrat in Rotation versetzt wird, um eine gleichmäßige Schichtdickenverteilung zu erhalten.

11. Vorrichtung zur Durchführung des Verfahrens nach den Ansprüchen 1 bis 10 umfassend eine Vakuumkammer, eine oder mehrere Vakuumpumpen, die mit der Vakuumkammer verbunden sind, Absperr- und Gaseinlaßventile, eine in der Vakuumkammer angeordnete Substratheizvorrichtung, wobei die Vakuumkammer einen oder mehrere Ausgänge aufweist, über die sie evakuierbar und flutbar ist, eine elektrisch isolierte Drehdurchführung, um die zu beschichtenden Substrate in Rotation zu versetzen, Mittel zum Befestigen des Substrates und der Verdampfungsquelle, die in der Vakuumkammer angeordnet sind und eine elektrische Versorgung für die Verdampferquelle und für das Substrat, **dadurch gekennzeichnet,** daß als Vakuumpumpe ausschließlich eine oder mehrere Vorvakuumpumpen angeordnet sind.

12. Vorrichtung nach Anspruch 11, dadurch gekennzeichnet, daß als Vorvakuumpumpe eine oder mehrere aus der Gruppe Hubkolbenvakuumpumpen, Membranvakuumpumpen, Flüssigkeitsringvakuumpumpen, Drehschiebervakuumpumpen, Vielzellenvakuumpumpen, Kreiskolbenvakuumpumpen, Sperrschiebervakuumpumpen, Wälzkolbenvakuumpumpen und Adsorptionsvakuumpumpen angeordnet sind.

13. Vorrichtung nach den Ansprüchen 11 oder 12, dadurch gekennzeichnet, daß mehrere Vorvakuumpumpen in Reihe geschaltet werden.

14. Vorrichtung nach den Ansprüchen 11 bis 13, dadurch gekennzeichnet, daß die Vorrichtung eine Drehschiebervakuumpumpe und Wälzkolbenvakuumpumpe enthält, wobei die Wälzkolbenvakuumpumpe in Strömungsrichtung vor der Drehschiebervakuumpumpe geschaltet ist.

15. Vorrichtung nach den Ansprüchen 11 bis 14, dadurch gekennzeichnet, daß die Verdampfungsquelle zur Vakuumkammer isoliert angeordnet ist.

16. Vorrichtung nach den Ansprüchen 11 bis 15, dadurch gekennzeichnet, daß die Verdampfungsquelle von einem Isolierring umschlossen ist und/oder hinter der Verdampfungsquelle ein Permanentmagnet oder eine elektrische Spule angeordnet ist, um ein Magnetfeld zu erzeugen.

17. Vorrichtung nach den Ansprüchen 11 bis 16, dadurch gekennzeichnet, daß die Substratheizvorrichtung eine Strahlungsheizung ist und im Innenraum der Vakuumkammer angeordnet ist.

18. Vorrichtung nach den Ansprüchen 11 bis 17, dadurch gekennzeichnet, daß die elektrische Versorgung für die Beschichtungsquelle stromgeregelt und für die Substrate spannungsgeregelt ist.

## Claims

1. A process for coating substrates, which comprises introducing the substrate to be coated into a vacuum chamber having one or more vaporization sources, evacuating the vacuum chamber and heating the substrate and coating the substrate using vaporization by arc discharge, characterized in that the vacuum chamber is evacuated solely using one or more forepumps.

2. The process according to claim 1, characterized in that piston vacuum pumps, diaphragm vacuum pumps, liquid piston vacuum pumps, rotary slide valve vacuum pumps, sliding vane vacuum pumps, annular piston vacuum pumps, rotating plunger vacuum pumps, rotary blower vacuum pumps, and adsorption vacuum pumps or combinations thereof are used as forepumps.

3. The process according to claim 1 or 2, characterized in that multiple forepumps are connected in series.

4. The process according to claims 1 to 3, characterized in that a combination of rotary slide valve vacuum pump and rotary blower vacuum pump is used, the rotary blower vacuum pump being connected before the rotary slide valve vacuum pump, relative to the flow direction.

5. The process according to claims 1 to 4, characterized in that the vacuum chamber during its evacuation is flooded with inert gas and re-evacuated once or several times.

6. The process according to claims 1 to 5, characterized in that a noble gas or a gas not reacting with the substrate is used as inert gas.

7. The process according to claims 1 to 6, characterized in that the pressure after evacuating is up to 10⁻⁴ mbars.

8. The process according to claims 1 to 7, characterized in that the coating is effected at substrate temperatures of from 100°C to 500°C.

9. The process according to claims 1 to 8, characterized in that after evacuating the vacuum chamber and during coating, a reactive gas is introduced into the vacuum chamber.

10. The process according to claims 1 to 9, characterized in that the substrate is rotated during coating in order obtain uniform layer thickness distribution.

11. A device for performing the process according to claims 1 to 10, comprising a vacuum chamber, one or more vacuum pumps connected to the vacuum chamber, back flow and gas inlet valves, a substrate heating device arranged in the vacuum chamber, the vacuum chamber having one or more outlets by means of which it can be evacuated and flooded, an electrically insulated rotary seal to rotate the substrate to be coated, means for holding the substrate and the vaporization source which are arranged in the vacuum chamber, and an electrical supply for the vaporizer source and the substrate, characterized in that one or more forepumps are arranged as the only vacuum pumps.

12. The device of claim 11, characterized in that one or more from the group of piston vacuum pumps, diaphragm vacuum pumps, liquid piston vacuum pumps, rotary slide valve vacuum pumps, sliding vane vacuum pumps, annular piston vacuum pumps, rotary plunger vacuum pumps, rotary blower vacuum pumps, and adsorption vacuum pumps are arranged as forepumps.

13. The device of claim 11 or 12, characterized in that multiple forepumps are connected in series.

14. The device of claims 11 to 13, characterized in that the device comprises a rotary slide valve vacuum pump and a rotary blower vacuum pump, the rotary blower vacuum pump being connected before the rotary slide valve vacuum pump, relative to the flow direction.

15. The device of claims 11 to 14, characterized in that the vaporization source is arranged so as to be insulated from the vacuum chamber.

16. The device of claims 11 to 15, characterized in that the vaporization source is enclosed by an insulating ring, and/or a permanent magnet or an electric coil is arranged behind the vaporization source in order to generate a magnetic field.

17. The device of claims 11 to 16, characterized in that the substrate heating device is a radiation heater arranged in the interior of the vacuum chamber.

18. The device of claims 11 to 17, characterized in that the electrical supply for the coating source is current-controlled, and the one for the substrates is voltage-controlled.

## Revendications

1. Procédé de revêtement de substrats, comprenant la mise en place du substrat à revêtir dans une chambre à vide avec une ou plusieurs source(s) d'évaporation, la réalisation du vide dans ladite chambre à vide et l'échauffement des substrats et le revêtement du substrat par l'intermédiaire d'une évaporation au moyen d'une décharge en arc, **caractérisé par le fait que** le vide est réalisé dans la chambre à vide exclusivement en utilisant une ou plusieurs pompe(s) à vide préliminaire.

2. Procédé selon la revendication 1, caractérisé par le fait que l'on utilise en tant que pompes à vide préliminaire des pompes à vide à piston alternatif, des pompes à vide à diaphragme, des pompes à vide à anneau liquide, des pompes à vide à palette, des pompes multipales, des pompes à vide à piston tournant, des pompes à vide à piston oscillant, des dépresseurs Roots et des pompes à vide à adsorption ou des combinaisons de ceux-ci.

3. Procédé selon les revendications 1 ou 2, caractérisé par le fait que plusieurs pompes à vide préliminaire sont montées en série.

4. Procédé selon les revendications 1 à 3, caractérisé par le fait que l'on utilise une combinaison de pompe à vide à palette et de dépresseur Roots, le dépresseur Roots étant monté, dans la direction d'écoulement, en amont de la pompe à vide à palette.

5. Procédé selon les revendications 1 à 4, caractérisé par le fait que, durant la réalisation du vide dans la chambre à vide, celle-ci est inondée une ou plusieurs fois de gaz inerte et est à nouveau évacuée.

6. Procédé selon les revendications 1 à 5, caractérisé par le fait que l'on utilise en tant que gaz inerte un gaz rare ou un gaz qui ne réagit pas avec le substrat.

7. Procédé selon les revendications 1 à 6, caractérisé par le fait que la pression après la réalisation du vide va jusqu'à 10⁻⁴ mbar.

8. Procédé selon les revendications 1 à 7, caractérisé par le fait que le revêtement est effectué à des températures de substrat comprises entre 100°C et 500°C.

9. Procédé selon les revendications 1 à 8, caractérisé par le fait qu'un gaz réactif est introduit dans la chambre à vide après la réalisation du vide dans la chambre à vide et durant le revêtement.

10. Procédé selon les revendications 1 à 9, caractérisé par le fait que, durant le revêtement, le substrat est mis en rotation afin d'obtenir une répartition uniforme de l'épaisseur de la couche.

11. Dispositif pour la mise en oeuvre du procédé selon les revendications 1 à 10, comprenant une chambre à vide, une ou plusieurs pompes à vide qui sont connectées à ladite chambre à vide, des soupapes d'arrêt et d'admission de gaz, un dispositif à chauffer les substrats, qui est disposé dans la chambre à vide, la chambre à vide présentant une ou plusieurs sorties par lesquelles on peut réaliser le vide dans celle-ci et elle peut être inondée, un passage tournant électriquement isolé pour mettre en rotation les substrats à revêtir, des moyens servant à fixer le substrat et la source d'évaporation qui sont disposés dans la chambre à vide, et une alimentation électrique pour la source d'évaporation et pour le substrat, **caractérisé par le fait que** l'on dispose en tant que pompe à vide exclusivement une ou plusieurs pompes à vide préliminaire.

12. Dispositif selon la revendication 11, caractérisé par le fait que l'on dispose en tant que pompe à vide préliminaire une ou plusieurs du groupe pompes à vide à piston alternatif, pompes à vide à diaphragme, pompes à vide à anneau liquide, pompes à vide à palette, pompes multipales, pompes à vide à piston tournant, pompes à vide à piston oscillant, dépresseurs Roots et pompes à vide à adsorption.

13. Dispositif selon les revendications 11 ou 12, caractérisé par le fait que plusieurs pompes à vide préliminaire sont montées en série.

14. Dispositif selon les revendications 11 à 13, caractérisé par le fait que le dispositif comprend une pompe à vide à palette et un dépresseur Roots, le dépresseur Roots étant monté, dans la direction d'écoulement, en amont de la pompe à vide à palette.

15. Dispositif selon les revendications 11 à 14, caractérisé par le fait que la source d'évaporation est disposée de manière isolée par rapport à la chambre à vide.

16. Dispositif selon les revendications 11 à 15, caractérisé par le fait que la source d'évaporation est enfermé d'un anneau isolant et/ou qu'un aimant permanent ou une bobine électrique est disposé derrière la source d'évaporation, afin de générer un champ magnétique.

17. Dispositif selon les revendications 11 à 16, caractérisé par le fait que le dispositif à chauffer les substrats est un chauffage à rayonnement et est disposé à l'intérieur de la chambre à vide.

18. Dispositif selon les revendications 11 à 17, caractérisé par le fait que l'alimentation électrique pour la source de revêtement est réglée par courant et celle pour les substrats est réglée par tension.
